# EUROPEAN PATENT SPECIFICATION

(11) **EP 2 366 975 B1**
(45) Date of publication and mention of the grant of the patent: **12.10.2016**
(21) Application number: 11158387.8
(22) Date of filing: 16.03.2011
(51) Int. Cl.: G01D 4/02, G01R 22/06

(54) **Consumption meter with a power supply**
Verbrauchsmessgerät mit einer Stromversorgung
Compteur de consommation doté d'une alimentation électrique

(30) Priority: 16.03.2010 EP 10156659
(43) Date of publication of application: 21.09.2011
(73) Proprietor: KAMSTRUP A/S, 8660 Skanderborg (DK)
(72) Inventor: Wester, Claus, DK-8660 Skanderborg (DK); Hansen, Søren Lund, DK-8654 Bryrup (DK); Hansen, Gorm Bass, DK-8722 Hedensted (DK)
(74) Representative: Plougmann Vingtoft a/s

(56) References cited:
- WO-A2-2009/032061
- US-A1- 2003 014 200
- US-A1- 2009 129 133

## Description

### FIELD OF THE INVENTION

The invention relates to electric devices with a power supply serving to convert an electric poly-phase power voltage level to a lower supply voltage level. Especially, the invention relates to devices involved in metering of utility consumption.

### BACKGROUND OF THE INVENTION

Devices involved in metering of a consumed amount of such utilities as water, gas, electricity or energy, e.g. in connection with heating or cooling, for charging purposes are frequently installed on the premises of the end-user, and at other distributed locations. Inspection, re-installation and repair, may therefore be time-consuming and costly.

An example of such a device is a consumption meter being powered from an alternating current AC electricity net. Such meters includes a power supply which serves to convert energy from the AC input at a high voltage level, to a lower supply voltage level suitable for powering the meter's electrical circuits. Such as circuits involved in measuring the consumed amount, communication circuits, etc.

During installation of a consumption meter installation errors may occur. One type of installation error is a missing connection to one of the electric phases or to the neutral conductor. Another type of installation error is an interchange of input terminals. Installation errors may lead to a non-functioning meter or in worst case a damaged meter. Such errors as loss of electrical connection to a phase or to neutral may also occur during normal use.

Another issue with consumption meters for charging purposes is tampering attempts. Removal of one of the phase connections or the neutral connection from the input of the meter is sometimes attempted with the purpose of deliberately stopping the meter from functioning and thus allowing the user to consume the metered quantity without charge.

Another aspect of consumption meters is that they are connected to a poly-phase AC input. With a RMS voltage of 230 V to neutral, as is commonly used in many domestic electricity nets, the phases can combine to a peak voltage of 560 V. Such high peak voltage puts certain requirements on the electric components as well as on the electrical layout used for the meter circuits.

ST Application Note to AN2264, revision 1.0, shows an example of a power supply which is tolerant with respect to a missing neutral conductor, and therefore somewhat tolerant to wiring errors and tampering attempts. The power supply has power input terminals to receive three electric phases and one neutral conductor. A rectifier circuit with two full bridges of diodes, i.e. altogether 8 diodes, serves to rectify the voltage from the four input terminals to provide a voltage input to a linear high voltage regulator serving to down-convert the output from the rectifier to a suitable low DC voltage. The full diode bridge provides a power supply which is tolerant with respect to a missing neutral conductor. However, to ensure that the resulting high voltage from the full bridge can be handled with low cost and compact components, such as normal switching and capacitor components rated to 400 V; a voltage drop is performed with a resistor. Using a resistor for this purpose means that the power supply is inefficient, since the resistor burns in the order of 2-3 W continuously with typical net supply voltages.

The voltage drop resistor can be avoided in case it is accepted to use electric components with a higher voltage rate, e.g. 700 V components. However, such components are expensive, have larger dimensions and such high voltages put strict demands on electric isolation and safety distances etc.

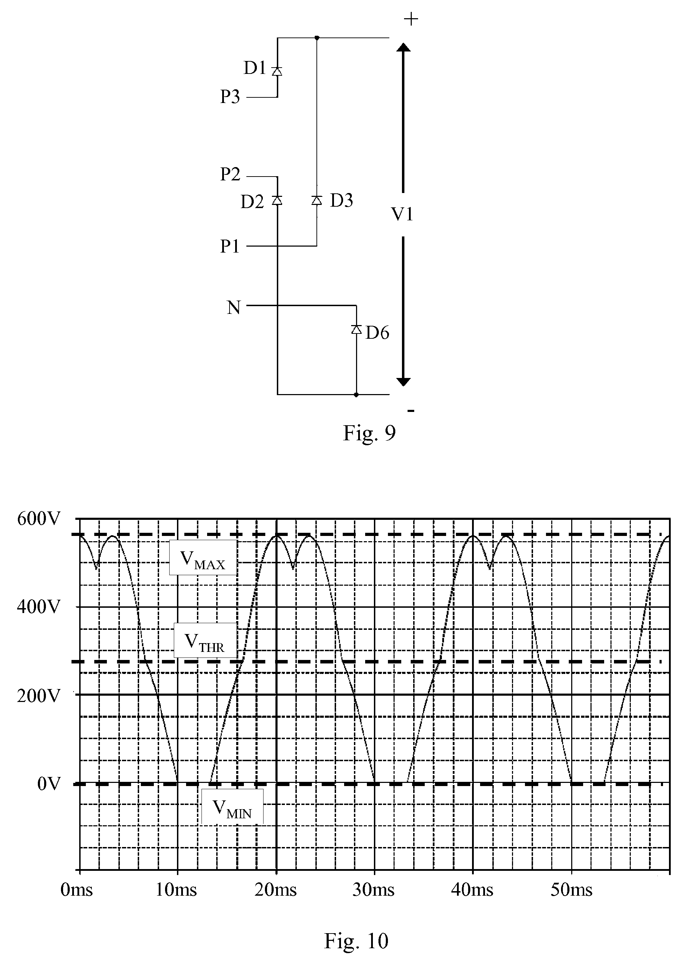

The published patent application US 2003/014200 A1 discloses an electrical power meter with a power supply utilizing high and low capacitive storage banks to supply sufficient energy to survive short duration power quality events which jeopardize the meter's operating power. The power supply utilizes a high voltage diode array arranged in the three phase full wave bridge configuration in connection with filtering the signal from the input lines, cf. section [0103] and Fig. 9A(4) in combination with resistors to limit the voltage drop, cf. Figs. 9A(5) and 9A(6).

The published patent application US 2009/0129133 discloses a method and an electronic circuit to convert high voltage mono-phase AC to low voltage DC. A rectifier in the form of a full-bridge diode rectifier bridge is used in combination with a gating component to convert power only in periods where an intermediate voltage is between zero volts and a preset threshold.

### SUMMARY OF THE INVENTION

It would be advantageous to achieve a consumption meter which is powered from a poly-phase electricity net, which is tolerant to at least some types of input wire faults, and which is energy efficient to operate and cost effective to produce. In general, the invention preferably seeks to mitigate, alleviate or eliminate one or more of the above-mentioned disadvantages, or other disadvantages of the prior art, singly or in any combination.

To achieve such a consumption meter there is provided a consumption meter as defined in claim 1.

Such a consumption meter is advantageous, since the combined effect of the rectification circuit and the active regulation circuit of the power supply ensures normal operation with a number of different and common types of wiring faults. The consumption meter is thus tolerant to a number of wiring errors. In embodiments, the meter ensures operation of at least the circuit arranged to measure the consumption data without damage to the electrical circuits of the meter, even with a missing neutral conductor, and in a case where three phases and one neutral conductor are connected to random ones of the input terminals, as well as other situations.

Moreover, with combined effect of the rectification circuit and the active regulation circuit of the power supply, it is possible to design the conversion circuit such that standard low cost 400 V rated components can be used for connection to a standard 50 Hz or 60 Hz poly-phase electric supply net with high voltage levels, i.e. phase to neutral peak voltages of the order of 300 V. This is enabled by the diode arrangement where the first voltage periodically drops below a predetermined threshold voltage, and by the active regulation circuit being arranged to convert energy from the intermediate terminals only in the periods where the first voltage is below the predetermined threshold. Thereby ensuring an output of the active regulation circuit never rises above the predetermined threshold, even in situation with a wiring error. The predetermined threshold may be set in the range between 200 V and 350 V.

The threshold is set so that it enables detecting the voltage drop. The choice of the specific level may be such that the threshold sets an upper limit for the maximal voltage a given component can be exposed to, i.e. it may set an upper limit of the voltage rating of at least certain components. On the other hand, it should be higher than a lower level required for driving the conversion circuit. Powering subsequent electronics by the energy that is tapped during the low voltage periods may be called a "selective diode" principle.

Furthermore, the rectification circuit can be designed without the need for a resistor-based voltage drop. This renders the operation more energy effective than circuits employing resistor-based voltage drops to lower the voltage rating.

In an advantageous embodiment, the periodic drop of the first voltage below the predetermined threshold voltage is obtained by a diode arrangement where both of the two intermediate terminals are connected to at least one of the input terminals via a diode, and at least one of the input terminals are connected to only one of the intermediate terminals via a diode. In such an embodiment, diodes are "missing" compared to a full bridge rectifier, and in contrast to the full bridge rectifier where the voltage remains at a high voltage level, low voltage periods occur where the voltage drops below the high voltage level defined by the full bridge rectifier. This enables the use of electrical components in the subsequent circuits with a lower voltage rating, than would be required if a full bridge rectifier circuit was used.

In an advantageous embodiment, the active regulation circuit comprises a voltage sensing circuit, such as a comparator, for sensing the first voltage, and arranged to generate an output when the first voltage drops below the predetermined threshold. The voltage sensing circuit may be arranged to control a switching device, e.g. a transistor, such that the switching device is in off-state in periods where the first voltage exceeds the predetermined threshold voltage, ensuring that only the low voltage period of the first voltage is utilized for the energy conversion.

In embodiments, the consumption meter is an electricity meter, and wherein the measurement circuit is arranged to measure electric energy delivered by three electric phases and neutral conductor from the AC power line. In other embodiments, the consumption meter may also comprise a flow meter, such as an ultrasonic flow meter, and wherein the measuring circuit is arranged to measure a fluid flow rate passing a measuring tube forming part of the flow meter.

In general the various aspects of the invention may be combined and coupled in any way possible within the scope of the invention. These and other aspects, features and/or advantages of the invention will be apparent from and elucidated with reference to the embodiments described hereinafter.

### BRIEF DESCRIPTION OF THE DRAWINGS

Embodiments of the invention will be described, by way of example only, with reference to the drawings, in which
Fig. 1 illustrates a block diagram of a consumption meter embodiment,
Fig. 2 illustrates a block diagram of a possible implementation of the power supply,
Fig. 3 illustrates a preferred rectification circuit embodiment with six diodes,
Fig. 4 illustrates a graph showing the first voltage V1 versus time for the rectification circuit embodiment of Fig. 3,
Fig. 5 illustrates a block diagram of an active regulation circuit design for the power supply,
Fig. 6 illustrates an electric diagram of a power supply circuit including rectification circuit and active regulation circuit
Fig. 7 illustrates another rectification circuit embodiment with five diodes,
Fig. 8 illustrates a graph showing the first voltage V1 versus time for the rectification circuit embodiment of Fig. 7,
Fig. 9 illustrates another rectification circuit embodiment with four diodes,
Fig. 10 illustrates a graph showing the first voltage V1 versus time for the rectification circuit embodiment of Fig. 9,
Fig. 11 illustrates yet another rectification circuit embodiment with seven diodes, and
Fig. 12 illustrates a graph showing the first voltage V1 versus time for the rectification circuit embodiment of Fig. 10.

### DESCRIPTION OF EMBODIMENTS

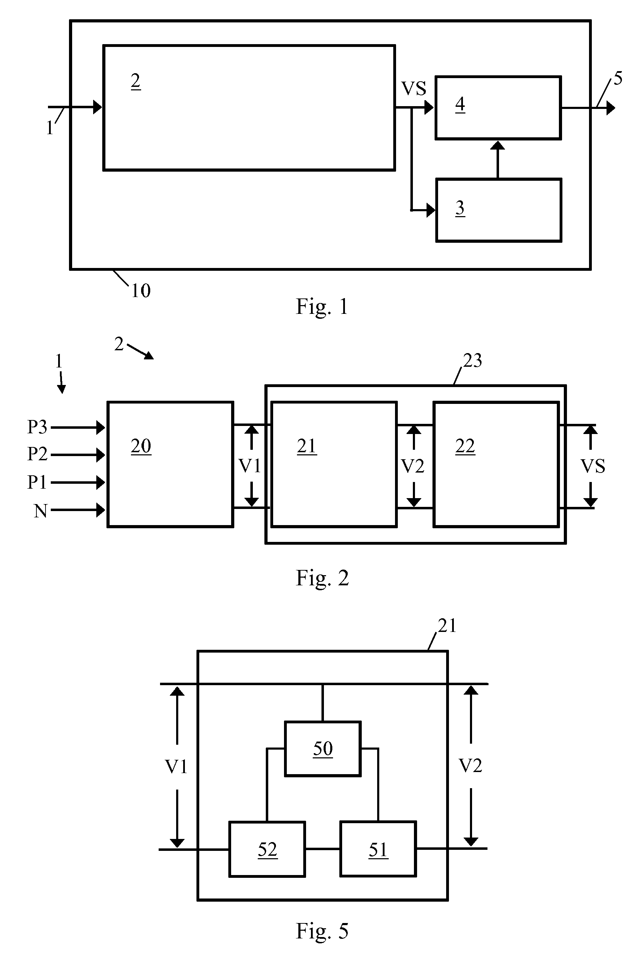

Fig. 1 shows a block diagram of elements of a consumption meter in accordance with embodiments of the invention. The consumption meter comprises, within a common casing 10, input terminals 1 for connection to an alternating current (AC) power line, a power supply 2, a measuring circuit 3 for measuring the consumption data representing the consumed amount of supplied utility, such as current and/or voltage sensing circuits and/or ultrasound flow meter circuits, and a communication circuit 4 for communicating the consumption data 5. The communication circuit need not be present, or may be implemented by the measuring circuit, e.g. to communicate the measured consumption data to a display. The communication circuit may be suitable for remote reading of the consumption data, and may comprise or be in the form of one or more of: a wired or wireless radio frequency (RF) transmitter, a circuit arranged for a dedicated wired communication link, a circuit arranged for communication on a power line, or any other suitable communication link. In the illustrated embodiment, the measuring circuit and the power supply is housed within a common casing, however the power supply may be arranged in a separate casing and arranged to power the consumption meter circuits with the supply voltage via a supply wire.

The power supply 2 serves to convert the high voltage power input from the power line, e.g. the public supply net, into a lower supply voltage VS which is used to power at least the measuring circuit 3, but typically also a communication circuit 4. The supply voltage normally is a DC supply voltage. Thus a conversion is made from a AC poly-phase net supply, e.g. where each phase has a RMS voltage to neutral of 230 V, which can combine to a peak voltage of 560 V, to a DC supply level suitable for driving the circuit of the meter, such as a DC level below 20 V, such as below 10 V, e.g. within the range of 1-10 V, such as 4 V. The power supply may in embodiments, also supply power to additional circuits of the device, and may generally be arranged to supply electric power to drive all of the low voltage electric circuits of the device.

Fig. 2 shows a block diagram of elements of a preferred a power supply 2 in accordance with embodiments of the present invention. The meter comprises a set of input terminals 1 for connection to the AC power line. In the present embodiment, the input terminals are for connection to three electric phases (P1-P3) and one neutral conductor (N) which is normal in connection to the public electric supply net. These input terminals are connected to a rectification circuit 20, which comprises a diode arrangement so as to combine the four single power terminals P1, P2, P3, N into a first voltage V1 between two intermediate terminals. The first voltage V1 is input into a conversion circuit 23 which is arranged to down-convert V1 into the supply voltage VS.

The conversion circuit 23 comprises an active regulation circuit 21 which serves to down-convert the first voltage V1 into a second voltage V2 which is lower than the first voltage V1, but higher than the supply voltage VS, e.g. from V1 = 560 V peak into V2 = 300 V DC. The second voltage V2 is then applied to a DC-to-DC converter 22, which down-converts the second voltage V2 to the supply voltage VS, e.g. by means of a switch mode circuit.

The rectification circuit 20 comprises the diode arrangement, where a network of preferably four to seven diodes are connected between the four input terminals P1-P3, N and two intermediate terminals over which the first voltage V1 is formed. The input phases are thus super-positioned to provide the first voltage, resulting in a voltage with a peak voltage which is higher than a peak voltage provided between any of the electric phases and neutral.

Further, the diodes of the rectification circuit are arranged such that in a limited time period of a whole electric period, i.e. in a sub-period of an electric period, the first voltage V1 drops below the peak voltage resulting in a temporal behaviour of the first voltage V1 wherein it periodically drops below at predetermined threshold, typically for a given sub-period of a whole electric period. The temporal properties of the first voltage V1 enable the design of a conversion circuit which utilizes the low voltage periods to tap electric energy from the first voltage V1.

It is to be understood, that the device may comprise an electric ground terminal as well.

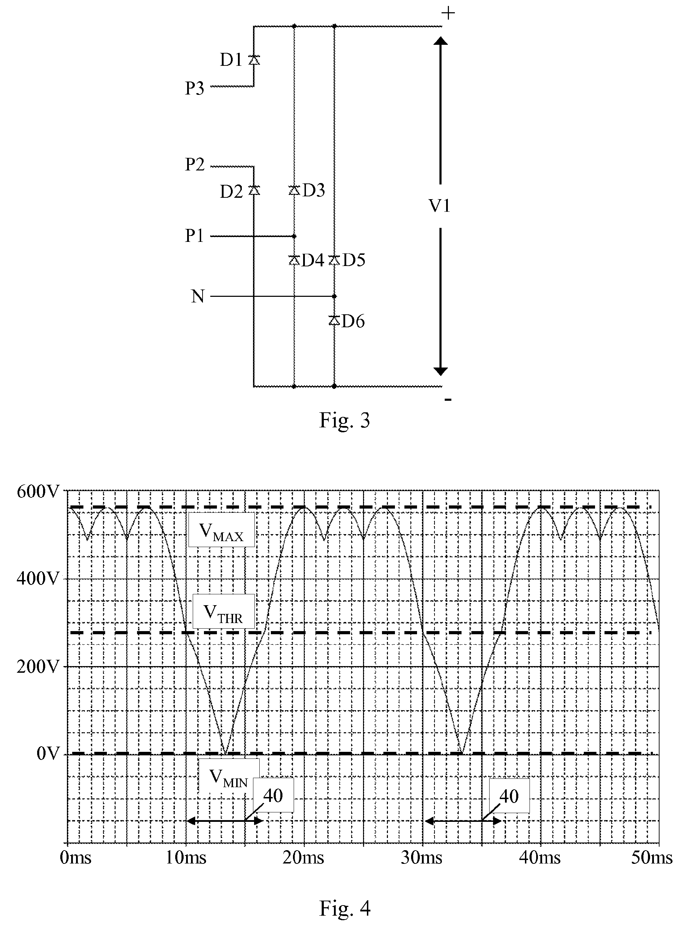

Fig. 3 shows an embodiment of a diode arrangement between the input terminals and the intermediate terminals. Six diodes D1-D6 are arranged between input terminals P1, P2, P3, N and two intermediate terminals + and - to provide the first voltage V1. The two diodes D1, D2 are connected such that the two phases P2, P3 are connected only to one terminal, namely the respective opposite terminals + and -. Input terminals P1 and N are both connected to both of the terminals + and -, namely via respective sets of diodes D3, D4 and D5, D6. The orientation of the diodes is obviously important and should preferably be as indicated.

Generally, two of the four input terminals are connected to both intermediate terminals + and - via respective sets of diodes, while the remaining two input terminals are connected to only one of the two intermediate terminals + and -. In other words, two diodes are omitted compared to a full bridge configuration of 8 diodes.

Fig. 4 shows the first voltage V1 with the diode configuration of Fig. 3, where the three phases P1, P2, P3 all provide a voltage level of 230 V RMS (325 V peak) to neutral N, and the AC frequency is 50 Hz (equal to an electric period of 20 ms). A maximum voltage V_{MAX} of 560 V is obtained, which is the same as the maximum voltage which would be observed also for a full bridge configuration of 8 diodes. However, as seen, there are periods during one electric period where the voltage drops down to a minimum voltage V_{MIN} of 0 V. Thus, during one electric period, the first voltage varies between a minimum voltage V_{MIN} which is lower than the peak voltage between one phase and neutral, and a maximum voltage V_{MAX} which is higher than the peak voltage between one phase and neutral.

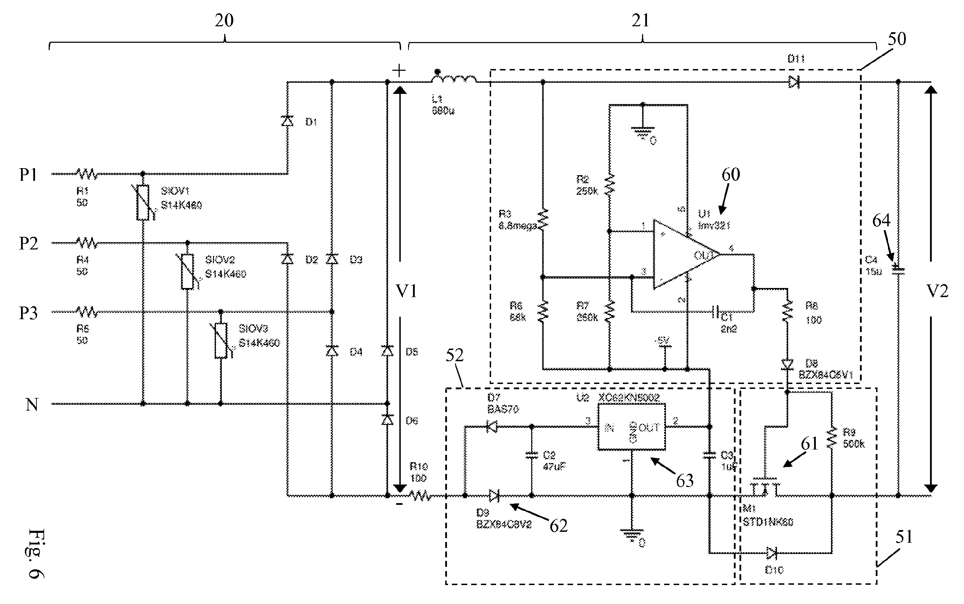

A predetermined threshold V_{THR} can be set so that the first voltage periodically drops below this threshold. These periods are indicated with the reference numeral 40. The specific duration of the low voltage periods depends on the threshold set. An example of how the threshold is set, is provided in connection with Fig. 6.

The diode arrangement shown in Fig. 3 is very tolerant to various installation errors, e.g. two arbitrary ones of the power inputs missing, or any intermixing of the four power inputs (including the neutral phase). Thus, e.g. neutral N alone, or the neutral and one phase may be completely omitted, and still normal function of the power supply can be obtained. In principle, P1, P2, P3, and N may be intermixed in any way on the four input terminals. However, it may be preferred that the neutral terminal is connected to both intermediate terminals + and -, such as shown in Fig. 3.

Fig. 5 shows a block diagram of elements of an embodiment of an active regulation circuit 21 in accordance with embodiments of the present invention. The regulation circuit comprises a voltage sensing circuit 50, a switching device 51 and a supply circuit 52 for supplying a supply voltage to the switching device.

The voltage sensing circuit 50 is connected so as to sense the first voltage V1 and to control a switching device 51 in accordance with the sensed voltage. With this configuration the switching device 51 can be controlled between "on" and "of" states by the voltage sensing circuit such that the switching device is "on" only in periods where the sensed voltage is below the predetermined threshold voltage.

Fig. 6 shows an electric diagram of a preferred embodiment of a rectification circuit 20 connected to an active regulation circuit 21.

The rectification circuit 20 outputs a first voltage V1 between the two intermediate terminals + and -, which serves as input for the active regulation circuit 21. The main elements of the rectification circuit have already been dealt with in connection with Fig. 3, and will not be elaborated on further.

The active regulation circuit 21 can be split into the three blocks as generally disclosed in Fig. 5.

The voltage sensing circuit 50 is based on a comparator circuit implemented with an operational amplifier U1 (ref. numeral 60). The operational amplifier U1 is coupled in an integrator configuration which provides a "sot" switching of the transistor M1 (ref. numeral 61), thus reducing electric noise transmitted back to the supply power line.

The transistor M1 with protection diode D10 forms the vital part of the switching device 51 which serves to tap energy only in low voltage periods of the first voltage V1 by switching to "of" state in other periods. Hereby transistor M1 can be rated at a voltage lower than the maximum voltage level of the first voltage V1.

In this embodiment, the threshold is primarily defined by the resistors R2, R3, R6 and R7 connected to the two inputs of the comparator U1.

The supply circuit 52 for providing a supply voltage to the switching device 51 and the voltage sensing circuit is based on a zener diode D9 (ref. numeral 62).

The zener diode D9 is connected such that it provides a voltage drop when current is drawn from the active regulation circuit, i.e. when the switching transistor M1 is in "on" state and further circuits connected to the V2 output terminals consume power. In other words, the zener diode D9 is connected in series with the current supplied by the power supply. Thus, when current is drawn from the power supply and M1 is "on", a voltage across the zener diode D9 will charge the capacitor C2. This voltage will vary significantly since the current through the zener diode D9 will be interrupted when M1 switches to "off" state. Therefore, a voltage regulator U2 (ref. numeral 63) follows the zener diode D9 and capacitor C2 to provide a stable voltage to M1.

The effect of the described supply circuit 52 is that it is very energy efficient, since it is avoided to reduce the high input voltage V1 by wasting power in a resistor, a method which inevitably wastes energy even if no power is drawn from the power supply. Thus, the power loss during standby-by is very low with the illustrated circuit, and furthermore the power loss will vary according to the power drawn from the power supply, and thus the absolute power loss is minimal when the power delivered by the power supply is low.

A capacitor C4 (ref. numeral 64) is connected across the V2 output terminals to provide a stable output voltage from the active regulation circuit to further downconverting circuits 22.

The shown circuit is suited to operate with electric phases P1, P2, P3 having RMS voltage levels to neutral of 230 V, and the resulting second voltage V2 is a DC voltage with a level of 300 V. This is suitable for a switch mode based DC-to-DC converter, in order to finally arrive at the voltage supply level.

The circuit of Fig. 6 will provide a power supply with a power loss which is proportional to the current supplied, and thus such circuit is suited to provide overall high power efficiency also for driving circuits which in most periods have low power consumption, such as the basic measuring circuit of a consumption meter.

It is to be understood that the circuit shown in Fig. 6 is an advantageous implementation. It can be modified with alternative or equivalent circuit solutions and still operate according to the scope of the invention. Moreover, in general, each single diode may be implemented by two or more elements.

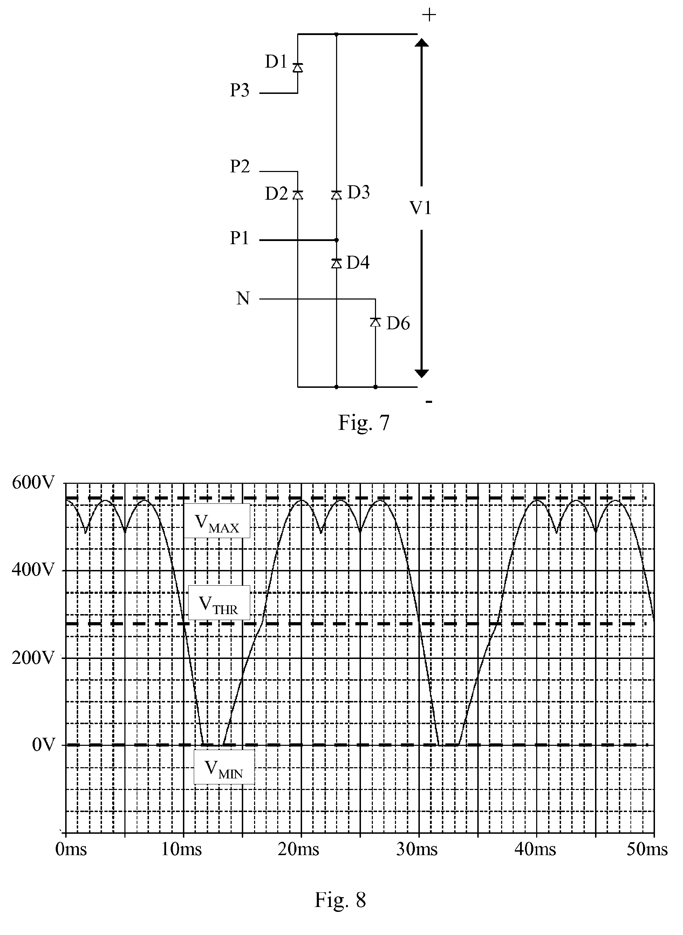

Figs. 7 and 8 show figures parallel with Figs. 3 and 4, i.e. diode arrangements and first voltage V1 for a diode arrangement with only five diodes. Thus, only one input terminal, here illustrated as P1, is connected via respective diodes to both of the intermediate terminals + and -. The other input terminals N, P2, P3 are only connected to one of the two intermediate terminals + and -. N and P1 are connected only to the - terminal, while P3 is connected only to the + terminal. One diode is saved compared to the embodiment of Fig. 3, however the disadvantage is that this rectification embodiment will not work with only P2 and N connected. E.g. P3 and N only will work, and provided that P1, P2 and P3 are present, the neutral N conductor can be omitted without disturbing the function of the power supply. It is to be understood that the only one input terminal which is connected to both intermediate terminals + and - may in principle be any one of the input terminals P1, P2, P3, N.

Fig. 8 shows the first voltage V1 resulting from the diode arrangement of Fig. 7. The electric power input at the terminals P1, P2, P3, and N is the same as described for Fig. 4. As seen, the same overall temporal properties of the first voltage V1 is observed as in Fig. 4, where a part of the whole electric period has a rather low voltage level below the peak voltage level between one phase and neutral. Thus, the same advantages can be obtained as already explained.

Figs. 9 and 10 also show figures parallel with Figs. 3 and 4, i.e. diode arrangement and first voltage V1 for yet another embodiment. The diode arrangement only has four diodes. All of the four input terminals P1, P2, P3, N are connected via respective diodes to one of the intermediate terminals + and -. Thus, none of the input terminals P1, P2, P3, N are connected via diodes to both of the intermediate terminals + and -. Two of the input terminals P1 and P3 are connected to one of the intermediate terminals + via respective diodes D3 and D1. N and P2 are connected only to the - terminal via respective diodes D6 and D2. Using only four diodes D1, D2, D3, D6 for a three-phase device, such rectification provides a simple and low cost solution, and still allows the power supply to function in case the neutral conductor N is missing, either due to an error or due to tampering attempts.

Fig. 10 shows the first voltage V1 resulting from the four diode arrangement of Fig. 9. The electric power input at the terminals P1, P2, P3, and N is the same as described for Fig. 4. As seen, the same overall temporal properties of the first voltage V1 is observed as in Fig. 5, where a part of the whole electric period has a rather low voltage level below the peak voltage level between one phase and neutral. Thus, the same advantages can be obtained as already explained.

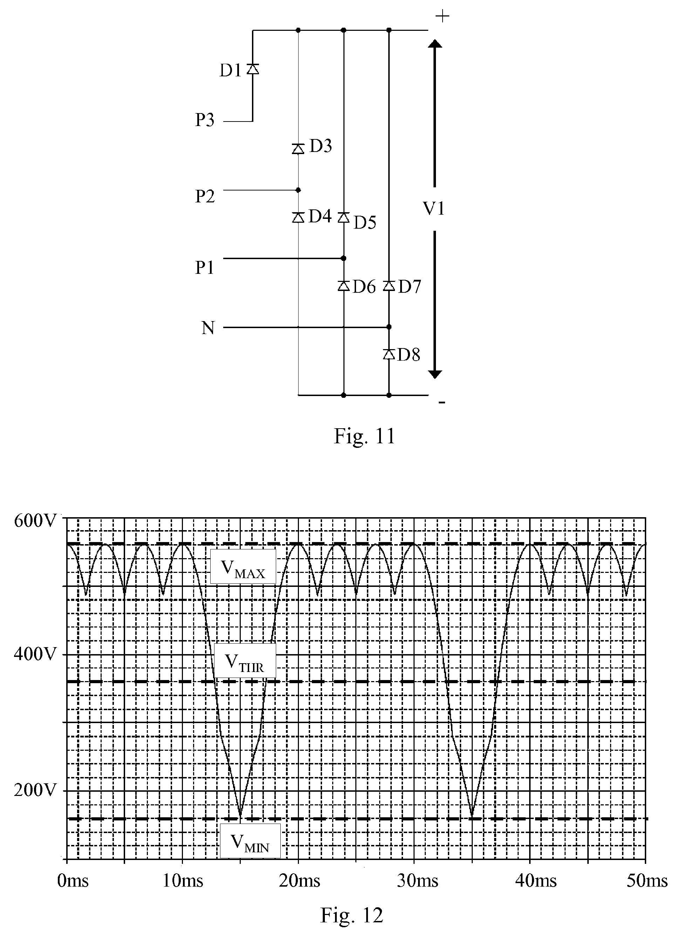

Figs. 11 and 12 show yet another set of figures parallel with Figs. 3 and 4, i.e. diode arrangement and first voltage V1 for yet another embodiment. The diode arrangement has seven diodes D1, D3-D8. Three of the four input terminals P1, P2, N are connected via respective diodes D3-D8 to both of the two intermediate terminals + and -, while one input terminal P3 is only connected via one diode D1 to terminal +. This embodiment has the same wiring tolerant properties described for the six diode configuration illustrated in Fig. 3, and still Fig. 12 shows that the seven diode embodiment has the same overall temporal properties for the first voltage V1 as explained also for the embodiments with fewer diodes.

Although the present invention has been described in connection with the specified embodiments, it should not be construed as being in any way limited to the presented examples. The invention can be implemented by any suitable means; and the scope of the present invention is to be interpreted in the light of the accompanying claim set. Any reference signs in the claims should not be construed as limiting the scope.

## Claims

1. A consumption meter powered from a three-phase electricity net and arranged for measuring consumption data of a supplied utility, the meter comprises:
- input terminals (1) arranged for connection to an alternating current power line with three electric phases (P1-P3) and one neutral conductor (N),
- a power supply (2) connected to the input terminals (1) and arranged to convert an input therefrom to a lower supply voltage (VS) for powering at least one circuit (3) arranged to measure the consumption data, the power supply (2) comprising:
- a rectification circuit (20) connected to the input terminals and arranged to form a first voltage (V1) between two intermediate terminals, the rectification circuit comprising a diode arrangement between the input terminals and the intermediate terminals, and
- a conversion circuit (23) arranged to down-convert the first voltage (V1) into the supply voltage (VS),
**characterized in that** the conversion circuit comprises an active regulation circuit (21) wherein
- the diode arrangement is arranged so that the first voltage periodically drops below a predetermined threshold voltage which is lower than a maximum voltage between the neutral and a superposition of the three electrical phases; and wherein
- the active regulation circuit is arranged to convert energy from the intermediate terminals only in periods where the first voltage is below the predetermined threshold.

2. A consumption meter according to claim 1, wherein the diode arrangement is such that both of the two intermediate terminals are connected to at least one of the input terminals via a diode, and at least one of the input terminals are connected to only one of the intermediate terminals via a diode.

3. Device according to claim 1 or 2, wherein the active regulation circuit (21) is arranged to down-convert the first voltage (V1) to a second voltage (V2) which is higher than the supply voltage (VS).

4. A consumption meter according to any of the preceding claims, wherein the active regulation circuit (21) comprises a voltage sensing circuit (50), for sensing the first voltage, and arranged to generate an output when the first voltage drops below the predetermined threshold.

5. A consumption meter according to claim 4, wherein the active regulation circuit (21) further comprises a switching device (51), and wherein the voltage sensing circuit (50) is arranged to control the switching device such that the switching device is in on-state in periods where the first voltage is below the predetermined threshold voltage.

6. A consumption meter according to claim 5, comprising a circuit (52) arranged to provide a supply voltage to the switching device (51), wherein the supply voltage has a reduced peak voltage level compared to a peak voltage level of the first voltage, and wherein the reduced peak voltage level is obtained without resistive voltage division.

7. A consumption meter according to claim 6, wherein the circuit (52) comprises a zener diode (62) connected in series with the switching device (51), so as to provide a voltage serving to charge a capacitor, upon current being drawn from the conversion circuit.

8. A consumption meter according to claim 7, comprising a voltage regulator circuit connected to take the voltage across the capacitor as input and to provide a supply voltage to the switching device as output.

9. A consumption meter according to any of the claims 3-8, wherein the conversion circuit (23) comprises a DC-to-DC converter comprising a switch-mode power supply arranged to down-convert the second voltage (V2) to the supply voltage (VS).

10. A consumption meter according to any of the preceding claims, wherein the power supply further generates supply voltage to supply additional circuits (4) of the device.

11. A consumption meter according to any of the preceding claims, wherein the consumption meter is one of: an electricity meter, a heat meter, a cooling meter, a gas meter, a water meter, and an energy meter.

## Patentansprüche

1. Verbrauchsmessgerät, betrieben über ein Drei-Phasen-Stromnetz und angeordnet zum Messen von Verbrauchsdaten eines gelieferten Versorgungsmediums, wobei das Messgerät umfasst:
- Eingangsanschlüsse (1), die zum Verbinden mit einer Wechselstrom-Stromleitung mit drei elektrischen Phasen (P1-P3) und einem Nullleiter (N) angeordnet sind,
- eine Stromversorgung (2), die mit den Eingangsanschlüssen (1) verbundenen und zum Umwandeln eines Eingangs davon in eine niedrigere Versorgungsspannung (VS) zum Betreiben mindestens eines Schaltkreises (3) angeordnet ist, der zum Messen der Verbrauchsdaten angeordnet ist, wobei die Stromversorgung (2) umfasst:
- einen Gleichrichterschaltkreis (20), der mit den Eingangsanschlüssen verbunden und zum Bilden einer ersten Spannung (V1) zwischen zwei Zwischenanschlüssen ausgebildet ist, wobei der Gleichrichterschaltkreis eine Diodenanordnung zwischen den Eingangsanschlüssen und den Zwischenanschlüssen umfasst, und
- einen Transformationsschaltkreis (23), der zum Heruntertransformieren der ersten Spannung (V1) in die Versorgungsspannung (VS) angeordnet ist,
**dadurch gekennzeichnet, dass** der Transformationsschaltkreis einen aktiven Regelschaltkreis (21) umfasst, wobei
- die Diodenanordnung derart angeordnet ist, dass die erste Spannung periodisch unter eine vorbestimmte Schwellenspannung abfällt, die niedriger ist als eine Höchstspannung zwischen dem Nullleiter und einer Überlagerung der drei elektrischen Phasen; und wobei
- der aktive Regelschaltkreis zum Umwandeln von Energie von den Zwischenanschlüssen nur in den Perioden angeordnet ist, in denen die erste Spannung unterhalb der vorbestimmten Schwelle liegt.

2. Verbrauchsmessgerät nach Anspruch 1, wobei die Diodenanordnung derart ist, dass beide der zwei Zwischenanschlüsse über eine Diode mit mindestens einem der Eingangsanschlüsse verbunden sind und mindestens einer der Eingangsanschlüsse über eine Diode nur mit einem der Zwischenanschlüsse verbunden ist.

3. Verbrauchsmessgerät nach Anspruch 1 oder 2, wobei der aktive Regelkreis (21) zum Heruntertransformieren der ersten Spannung (V1) auf eine zweite Spannung (V2) angeordnet ist, die höher ist als die Versorgungsspannung (VS).

4. Verbrauchsmessgerät nach einem der vorhergehenden Ansprüche, wobei der aktive Regelkreis (21) einen Spannungserfassungsschaltkreis (50) zum Erfassen der ersten Spannung umfasst und zum Generieren einer Ausgabe angeordnet ist, wenn die erste Spannung unter die vorbestimmte Schwelle abfällt.

5. Verbrauchsmessgerät nach Anspruch 4, wobei der aktive Regelkreis (21) weiterhin eine Schaltvorrichtung (51) umfasst und wobei der Spannungserfassungsschaltkreis (50) zum Steuern der Schaltvorrichtung angeordnet ist, sodass die Schaltvorrichtung in Perioden, in denen die erste Spannung unter der vorbestimmten Schwellenspannung liegt, in eingeschaltetem Zustand ist.

6. Verbrauchsmessgerät nach Anspruch 5, umfassend einen Schaltkreis (52), der zum Bereitstellen einer Versorgungsspannung an der Schaltvorrichtung (51) angeordnet ist, wobei die Versorgungsspannung ein im Vergleich zu einem Spitzenspannungsniveau der ersten Spannung reduziertes Spitzenspannungsniveau hat und wobei das reduzierte Spitzenspannungsniveau ohne ohmsche Spannungsteilung erhalten wird.

7. Verbrauchsmessgerät nach Anspruch 6, wobei der Schaltkreis (52) eine ZenerDiode (62) umfasst, die in Reihe mit der Schaltvorrichtung (51) verbunden ist, um so eine Spannung bereitzustellen, die zum Laden eines Kondensators dient, wenn der Transformationsschaltkreis Strom verbraucht.

8. Verbrauchsmessgerät nach Anspruch 7, umfassend einen Spannungsregelkreis, der derart angeschlossen ist, dass die Spannung als Eingabe am Kondensator angelegt und eine Versorgungsspannung an der Schaltvorrichtung als Ausgabe bereitgestellt wird.

9. Verbrauchsmessgerät nach einem der Ansprüche 3-8, wobei der Transformationsschaltkreis (23) einen DC-zu-DC-Wandler umfasst, umfassend ein Schaltnetzteil, der zum Heruntertransformieren der zweiten Spannung (V2) auf die Versorgungsspannung (VS) angeordnet ist.

10. Verbrauchsmessgeräte nach einem der vorhergehenden Ansprüche, wobei das Netzteil weiterhin eine Versorgungsspannung zur Versorgung zusätzlicher Schaltkreise (4) der Vorrichtung erzeugt.

11. Verbrauchsmessgerät nach einem der vorhergehenden Ansprüche, wobei das Verbrauchsmessgerät entweder ein Strommessgerät, ein Wärmemessgerät, ein Kältemessgerät, ein Gasmessgerät, ein Wassermessgerät oder ein Energiemessgerät ist.

## Revendications

1. Compteur de consommation alimenté par un réseau électrique triphasé et disposé pour mesurer des données de consommation d'une commodité fournie, le compteur comprenant :
- des bornes d'entrée (1) disposées pour être raccordées à une ligne d'alimentation en courant alternatif possédant trois phases électriques (P1-P3) et un conducteur neutre (N),
- une alimentation (2) raccordée aux bornes d'entrée (1) et disposée pour convertir une entrée provenant de celles-ci en une tension d'alimentation (VS) plus basse pour alimenter au moins un circuit (3) disposé pour mesurer les données de consommation, l'alimentation (2) comprenant :
- un circuit redresseur (20) raccordé aux bornes d'entrée et disposé pour former une première tension (V1) entre deux bornes intermédiaires, le circuit redresseur comprenant un système de diodes entre les bornes d'entrée et les bornes intermédiaires, et
- un circuit de conversion (23) disposé pour abaisser la première tension (V1) jusqu'à la tension d'alimentation (VS),
**caractérisé en ce que** le circuit de conversion comprend un circuit de régulation actif (21) dans lequel
- le système de diodes est disposé de manière à ce que la première tension chute périodiquement au-dessous d'un seuil de tension prédéterminé qui est inférieur à une tension maximum entre le neutre et une superposition des trois phases électriques ; et dans lequel
- le circuit de régulation actif est disposé pour convertir l'énergie provenant des bornes intermédiaires uniquement dans les périodes où la première tension est inférieure au seuil prédéterminé.

2. Compteur de consommation selon la revendication 1, dans lequel le système de diodes est tel que les deux bornes intermédiaires sont raccordées à au moins une des bornes d'entrée via une diode, et au moins une des bornes d'entrée est raccordée à une seule des bornes intermédiaires via une diode.

3. Dispositif selon la revendication 1 ou 2, dans lequel le circuit de régulation actif (21) est disposé pour abaisser la première tension (V1) jusqu'à une deuxième tension (V2) qui est supérieure à la tension d'alimentation (VS).

4. Compteur de consommation selon l'une quelconque des revendications précédentes, dans lequel le circuit de régulation actif (21) comprend un circuit de détection de tension (50), pour détecter la première tension, et est disposé pour générer une sortie quand la première tension chute au-dessous du seuil prédéterminé.

5. Compteur de consommation selon la revendication 4, dans lequel le circuit de régulation actif (21) comprend également un dispositif de commutation (51), et dans lequel le circuit de détection de tension (50) est disposé pour commander le dispositif de commutation de manière à ce que le dispositif de commutation soit dans un état activé dans des périodes où la première tension est inférieure au seuil de tension prédéterminé.

6. Compteur de consommation selon la revendication 5, comprenant un circuit (52) disposé pour fournir une tension d'alimentation au dispositif de commutation (51), dans lequel la tension d'alimentation possède un niveau de tension de crête réduit par comparaison à un niveau de tension de crête de la première tension, et dans lequel le niveau de tension de crête réduit est obtenu sans division de tension résistive.

7. Compteur de consommation selon la revendication 6, dans lequel le circuit (52) comprend une diode Zener (62) raccordée en série au dispositif de commutation (51), de manière à fournir une tension permettant de charger un condensateur, lorsque du courant est prélevé sur le circuit de conversion.

8. Compteur de consommation selon la revendication 7, comprenant un circuit régulateur de tension raccordé pour utiliser la tension traversant le condensateur comme entrée et pour fournir une tension d'alimentation au dispositif de commutation en sortie.

9. Compteur de consommation selon l'une quelconque des revendications 3 à 8, dans lequel le circuit de conversion (23) comprend un convertisseur CC-CC comprenant une alimentation à découpage disposée pour abaisser la deuxième tension (V2) jusqu'à la tension d'alimentation (VS).

10. Compteur de consommation selon l'une quelconque des revendications précédentes, dans lequel l'alimentation génère également une tension d'alimentation pour alimenter d'autres circuits (4) du dispositif.

11. Compteur de consommation selon l'une quelconque des revendications précédentes, dans lequel le compteur de consommation est de l'un des types suivants : compteur d'électricité, compteur de chaleur, compteur de refroidissement, compteur de gaz, compteur d'eau et compteur d'énergie.
